# EUROPEAN PATENT APPLICATION

(11) **EP 2 482 312 A2**
(43) Date of publication of application: **01.08.2012**
(21) Application number: 11777154.3
(22) Date of filing: 29.04.2011
(51) Int. Cl.: H01L 23/58, H01L 25/16, H02M 1/00

(54) **POWER SUPPLY MODULE AND PACKAGING AND INTEGRATING METHOD THEREOF**

(71) Applicant: Huawei Technologies Co., Ltd., Shenzhen, Guangdong 518129 (CN)
(72) Inventor: MAO, Hengchun, Shenzhen Guangdong 518129 (CN); CHEN, Kai, Shenzhen Guangdong 518129 (CN); DUAN, Zhihua, Shenzhen Guangdong 518129 (CN); ZHOU, Tao, Shenzhen Guangdong 518129 (CN)
(74) Representative: Thun, Clemens
(86) International application number: PCT/CN2011/073523
(87) International publication number: WO 2011/137733

(57) **Abstract**

A power supply module and a packaging and integrating method thereof are provided. The power supply module includes a lead frame, a passive element, an integrated circuit IC, and a power switch Metallic Oxide Semiconductor Field Effect Transistor MOSFET. The passive element is soldered onto the lead frame by using the surface mount technology. The IC is a flip chip and is mounted and soldered onto the lead frame.

## Description

### FIELD OF THE INVENTION

The present invention relates to the field of power supply equipment technologies, and in particular, to a power supply module and a packaging and integrating method thereof.

### BACKGROUND OF THE INVENTION

Main components of a power supply module include a power switch, a control IC (Integrated circuit, integrated circuit), an input capacitor, an output capacitor, a power inductor, and a resistor and a capacitor which are configured for signal processing. The power switch is often an MOSFET (Metallic Oxide Semiconductor Field Effect Transistor, metallic oxide semiconductor field effect transistor) or an IGBT(Insulated Gate Bipolar Transistor, insulated gate bipolar transistor), and the control IC may be a driver chip, or a PWM (Pulse Width Modulation, pulse width modulation) control chip, or a combination of the two. At present, power supply and semiconductor manufacturers are all developing packaging and integrating technologies of the power supply module, integration schemes of the power supply manufacturers and the semiconductor manufacturers gradually produce an intersection in the field of semiconductor packaging and integrating on the chip level, structures such as the MOSFET, the IC, and the passive element (such as an inductor, a resistor, and a capacitor) are often used, a PCB (Printed Circuit Board, printed circuit board) or other substrates are embedded, and an interconnection manner of gold wire or copper wire bonding is adopted. The MOSFET, as the switch, is controlled or driven by the IC to complete the pulse width modulation of the input voltage, and output the voltage required by a load after filtering by the inductor and the capacitor.

In power supply modules of the prior art, the inductor may be formed by soldering multiple copper pieces with a copper lead frame and additionally adding a magnetic core, and may also be formed by soldering a ready inductance component onto the copper lead frame by using the SMT (Surface Mount Technology, surface mount technology). According to the different integration manner of the IC and the MOSFET, the packaging and integrating structure of the power supply module is also different, which mainly has the following two manners:

1. The IC and the MOSFET may be integrated on one chip, an IC and an MOSFET integrated chip are connected to the lead frame and the inductor through the gold wire bonding.

2. The IC and the MOSFET are independent chips, the IC is assembled on the PCB, the PCB is then assembled on the lead frame, and the IC and the MOSFET chip are interconnected through the gold wire or copper wire bonding.

Whatever kind of the packaging and integrating structure is, multiple gold wires or copper wires for bonding are required for electrical connection, so that the costs are high. Further, the gold wire bonding process has defects, such as the diameter of the gold wire is small, the wire length is large, so that parasitic parameters such as parasitic impedance during heat dissipation and working are not ideal and the power efficiency is affected. In addition, for the above second manner, a layer of PCB interconnection is added, the degree of technical difficulty of the process and the cost are increased.

### SUMMARY OF THE INVENTION

Embodiments of the present invention provide a power supply module and a packaging and integrating method thereof to solve the problems in the prior art that parasitic parameters may be increased, the heat dissipation performance and the power efficiency are affected because of using the connection manner of the gold wire bonding, and simplify the interconnection manner.

In order to solve the above technical problems, the technical solutions adopted by the embodiments of the present invention are as follows:

A power supply module includes a lead frame, a passive element, an integrated circuit IC, and a power switch Metallic Oxide Semiconductor Field Effect Transistor MOSFET. The passive element is soldered onto the lead frame by using the surface mount technology. The IC is a flip chip and is mounted and soldered onto the lead frame by using a flip-chip technology.

A packaging and integrating method of a power supply module includes:
soldering a passive element onto a lead frame by using the surface mount technology;
mounting and soldering a flip chip on which a power switch Metallic Oxide Semiconductor Field Effect Transistor MOSFET and an integrated circuit IC are integrated to the lead frame by using the flip-chip technology to form a power supply module;
plastic encapsulating the power supply module; and
separating the power supply module after the plastic encapsulating is completed.

A packaging and integrating method of a power supply module includes:
soldering a passive element onto a lead frame by using the surface mount technology;
soldering each of two power switch Metallic Oxide Semiconductor Field Effect Transistor MOSFET chips onto the lead frame;
mounting and soldering a flip-chip mode integrated circuit IC chip onto the lead frame to form a power supply module;
plastic encapsulating the power supply module;
separating the power supply module after the plastic encapsulating is completed.

A packaging and integrating method of a power supply module, includes:
soldering a passive element onto a lead frame by using the surface mount technology;
mounting and soldering a flip-chip mode integrated circuit IC chip onto the lead frame by using a flip-chip technology;
alternately stacking and mounting two power switch Metallic Oxide Semiconductor Field Effect Transistor MOSFET chips and two copper pieces to achieve electrical connection of the MOSFET chips to the lead frame to form a power supply module;
plastic encapsulating the power supply module; and
separating the power supply module after the plastic encapsulating is completed.

In the power supply module and the packaging and integrating method thereof provided in the embodiments of the present invention, the passive element is soldered onto the lead frame by using the surface mount technology. The IC is designed as a flip chip and is mounted and soldered onto the lead frame by using the flip-chip technology without the need of connection through gold wire or copper wire bonding, and a connection distance between the chip and the lead frame is short, so that the parasitic parameters are effectively decreased and the heat dissipation performance and the power efficiency are effectively improved.

### BRIEF DESCRIPTION OF THE DRAWINGS

To describe the technical solutions according to the embodiments of the present invention or in the prior art more clearly, the accompanying drawings for describing the embodiments or the prior art are introduced briefly in the following. Apparently, the accompanying drawings in the following description are only some embodiments of the present invention, and persons of ordinary skill in the art can derive other drawings from the accompanying drawings without creative efforts.

FIG. 1 is a schematic connection diagram of a flip chip and a lead frame according to an embodiment of the present invention;

FIG. 2 is a schematic diagram of a single-chip structure of a power supply module according to an embodiment of the present invention;

FIG. 3 is a schematic diagram of another single-chip structure of a power supply module according to an embodiment of the present invention;

FIG. 4 is a schematic diagram of another single-chip structure of a power supply module according to an embodiment of the present invention;

FIG. 5 is a schematic diagram of another single-chip structure of a power supply module according to an embodiment of the present invention;

FIG. 6 is a schematic diagram of a tri-chip structure of a power supply module according to an embodiment of the present invention;

FIG. 7 is a schematic connection diagram of a flip MOSFET chip with a vertical structure and a lead frame according to an embodiment of the present invention;

FIG. 8 is a schematic connection diagram of a normal MOSFET chip of a vertical structure and a lead frame according to an embodiment of the present invention;

FIG. 9 is a schematic connection diagram of a flip MOSFET chip of a planar structure and a lead frame according to an embodiment of the present invention;

FIG. 10 is a schematic connection diagram of a normal MOSFET chip with a planar structure and a lead frame according to an embodiment of the present invention; and

FIG. 11 is a schematic diagram of another tri-chip structure of a power supply module according to an embodiment of the present invention.

### DETAILED DESCRIPTION OF THE EMBODIMENTS

To make persons in the art better understand the solutions of according to embodiments of the present invention, the embodiments of the present invention are described below in further detail with reference to the accompanying drawings and implementation.

For some problems existing in the power supply module in which the connection of the gold wire or copper wire bonding is used in the prior art, an embodiment of the present invention provides a power supply module, which includes: a lead frame, a passive element, an integrated circuit IC, and MOSFETs. Passive elements include passive elements such as a power inductor, an input capacitor, an output capacitor, and a resistor. The passive elements are soldered onto the lead frame by using the surface mount technology. In the embodiment of the present invention, the IC is a flip chip and is mounted and soldered onto the lead frame by using the flip-chip technology. The IC may act as a driver chip of the MOSFETs.

In the power supply module, generally two MOSFETs are required. Therefore, in the power supply module of the embodiment of the present invention, two MOSFETs and the IC may be integrated on one flip chip (a single-chip structure for short); or the two MOSFETs may be designed as two chips independent of the IC (a tri-chip structure for short), and in this case, the two MOSFET chips may be designed as flip chips or normal chips.

The flip chip and the normal chip refer to two types of chip having different packaging manners.

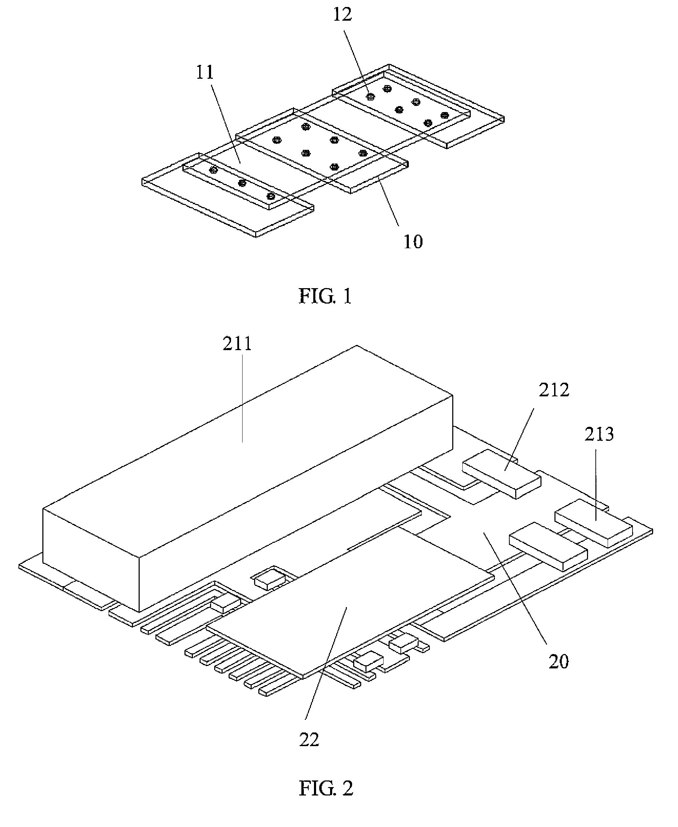

The packaging manner of the flip chip is that a front side of the chip face downwards towards a substrate to form a shortest circuit without lead bonding, thereby reducing the resistance; a metal solder joint such as a copper stud solder joint or a tin ball solder joint that exists below the flip chip, the connection manner in which the flip chip and the lead frame are connected is as shown in FIG. 1, a flip chip 11 is soldered onto a lead frame 10 through metal solder joints 12.

The normal chip is a chip with a conventional structure and is connected to the lead frame through a bottom surface of the chip.

The single-chip structure and the tri-chip structure are taken as examples to further describe the power supply module of the embodiment of the present invention.

As shown in FIG. 2, FIG. 2 is a schematic diagram of a single-chip structure according to an embodiment of the present invention;

In this embodiment, passive elements 211, 212, 213 are soldered onto a lead frame 20 by using the surface mount technology. The passive elements may specifically be inductors, capacitors, and resistors. Two MOSFETs and an IC are integrated on a flip chip 22, and the flip chip 22 is mounted and soldered onto the lead frame 20 by using the flip-chip technology.

The lead frame 20 in this embodiment may be of an array structure, that is, multiple modules are arranged in matrix in the lead frame.

The following assembling sequence may be used for integrating the power supply module with such a structure:

(1) The passive elements are soldered onto the lead frame by using the surface mount technology.

(2) After being cleaned, the flip chip on which the MOSFETs and the IC are integrated is mounted and soldered to the lead frame by using the flip-chip technology, and then the whole module is cleaned.

(3) Filling adhesive is filled in the bottom of the flip chip by using the underfill technology and cured in the bottom of the flip chip, and then the whole module is cleaned.

(4) The whole module is plastic encapsulated by using the plastic encapsulation technology.

(5) The power supply module is separated through stamping separation or cutting separation after the plastic encapsulating is completed.

It should be noted that, the processes of the cleaning in steps (2) and (3) or the underfill process in step (3) is optional, whether the cleaning processes and the underfill process are performed may be determined according to actual needs.

In addition, in an actual application, the above assembling sequence may be adjusted flexibly. For example, the flip chip is assembled first, and then the passive elements are assembled.

It can be seen that, in the power supply module in the embodiment of the present invention, without the need of connection through the gold wire or the copper wire bonding, the MOSFETs and the IC are directly mounted to the lead frame through the flip chip, and a connection distance between the chip and the lead frame is short, so that the parasitic parameters are effectively decreased and the heat dissipation performance and the power efficiency are effectively improved.

In order to further improve the heat dissipation performance of the power supply module, in the embodiment of the present invention, a copper piece may also be disposed on a back surface of the flip chip on which the MOSFETs and the IC are integrated, so as to facilitate heat dissipation and reduce electrical noise. The copper piece may be soldered onto the back surface of the flip chip or adhere to the back surface of the flip chip through high thermal conductive adhesive. Through an appropriate chip design, the two MOSFETs integrated on the chip are all designed as the vertical structure or partially designed as the vertical structure, electrodes of the MOSFETs may be on an upper surface of the chip, the copper piece may also, as an external connection line of the MOSFET electrodes, provide an electrical connection function.

In an actual application, the structure, the mounting position and the mounting manner of the copper piece may be flexibly designed according to the size and the assembling position of the flip chip, which is not limited by the embodiment of the present invention, and examples are provided below for illustration only.

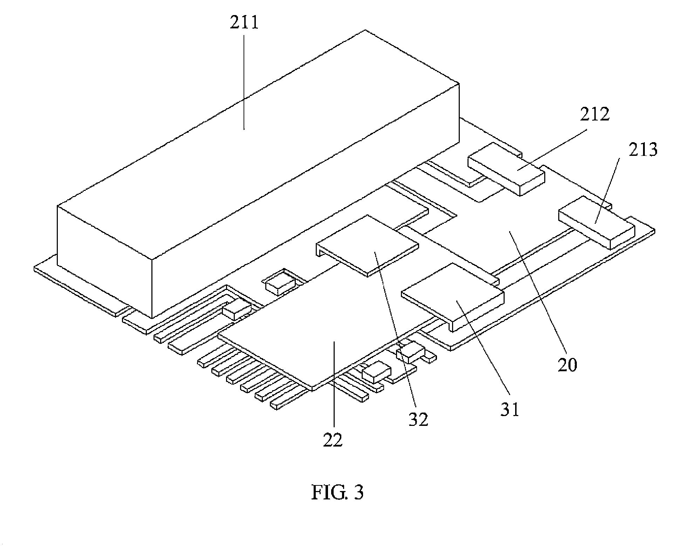

As shown in FIG. 3, FIG. 3 is a schematic diagram of another single-chip structure of a power supply module according to an embodiment of the present invention.

Different from the embodiment shown in FIG. 2, in this embodiment, two copper pieces 31, 32 are mounted to the back surface of the flip chip 22. The copper pieces 31, 32 are connected to the lead frame 20 through their respective bent edges. The copper pieces 31, 32 not only play roles of heat dissipation and electrical noise reduction, but also provide, as an external connection line of the electrodes of the MOSFETs, the electrical connection function when the two MOSFETs integrated on the chip are designed as the vertical structure.

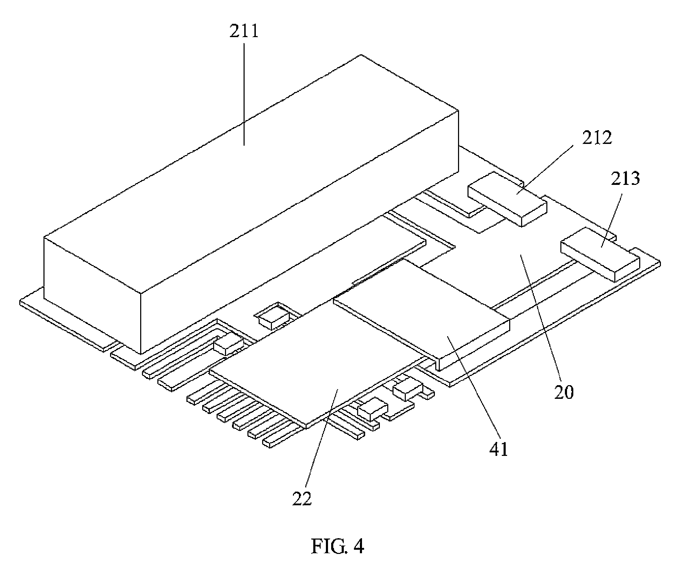

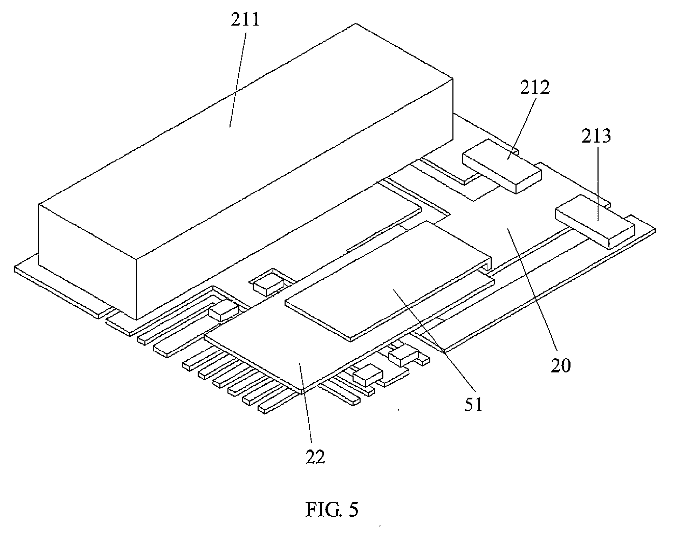

As shown in FIG. 4 and FIG. 5, FIG. 4 and FIG. 5 are schematic diagrams of structural variations of the power supply module with the single-chip structure shown in FIG. 3.

In the two structures, a copper piece, such as a copper piece 41 shown in FIG. 4 and a copper piece 51 shown in FIG. 5, is mounted to the back surface of the flip chip 22. A difference between the copper pieces shown in FIG. 4 and FIG. 5 lies in that, the bent edges of the copper pieces are connected to different positions of the lead frame 20.

Similarly, in the two structures, the copper pieces 31, 32 not only play roles of heat dissipation and electrical noise reduction, but also provide, as an external connection line of the electrodes of the MOSFET, the electrical connection function when one MOSFET integrated on the chip is designed as the vertical structure. The other MOSFET in the chip may be designed as the planar structure and is connected to the lead frame through solder balls of the flip chip or connected to the one MOSFET directly through an internal structure of the chip.

Definitely, in an actual application, the power supply module may further have other structural variations, which are not described through examples one by one herein.

The assembling and integrating processes of the power supply modules shown in FIG. 3 to FIG. 5 are similar to the assembling and integrating processes of the power supply module shown in FIG. 2, and are not repeated herein. In the above embodiment of the single-chip structure, in an alternative solution of the copper piece, for 31, 32 in FIG. 3, 41 in FIG. 4, 51 in FIG. 5, an aluminum strip may be used to replace the copper piece, the aluminum strip is soldered onto a corresponding chip surface and a lead frame surface by using the aluminum line and aluminum strip soldering technology. The aluminum strip is a strip-shaped interconnecting material with the shape similar to that of the copper piece.

As mentioned in the preceding, in the power supply module of the embodiment of the present invention, the two MOSFETs and the IC may be integrated on one flip chip (a single-chip structure for short); or two MOSFETs may be designed as two chips independent of the IC (a tri-chip structure for short), and in this case, the two MOSFETs may be designed as flip chips or normal chips.

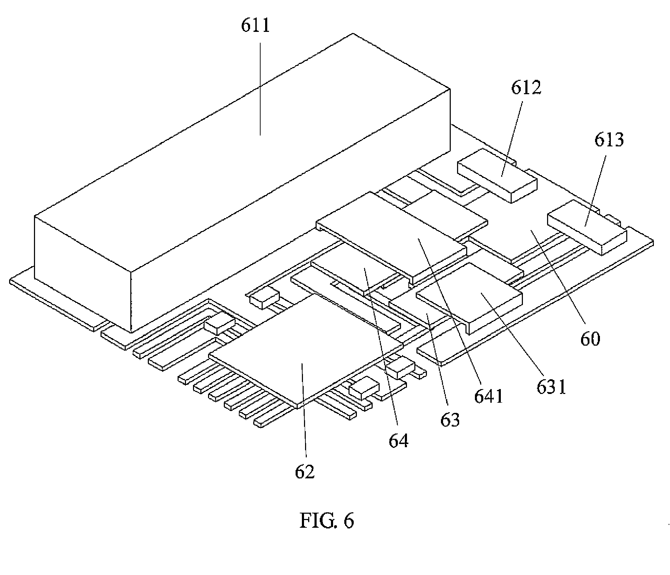

As shown in FIG. 6, FIG. 6 is a schematic diagram of a tri-chip structure of a power supply module according to an embodiment of the present invention.

In this embodiment, passive elements 611, 612, 613 are soldered onto a lead frame 60 by using the surface mount technology. The passive elements may specifically be inductors, capacitors, and resistors. An IC and two MOSFETs are three independent chips, which are an IC chip 62 and MOSFET chips 63, 64 shown in the drawing. The IC chip 62 is a flip chip and is mounted and soldered onto the lead frame 60 by using a flip-chip technology; the two MOSFET chips 63, 64 may be flip chips or normal chips, and each of them soldered onto the lead frame 60 through the manner corresponding to chip packaging.

The MOSFET chip 63 is connected to the lead frame 60 through a copper piece 631, and the MOSFET chip 64 is connected to the lead frame 60 through a copper piece 641. Each of the copper piece 631 and the copper piece 641 is connected to their respective MOSFET chips and the lead frame 60 through the soldering or the adhering manner (such as adhering through adhesive of high thermal conductivity), so as to connect the MOSFET chips to the lead frame 60 and interconnect the two MOSFET chips.

The lead frame 60 in this embodiment may be of an array structure, that is, multiple modules are arranged in matrix in the lead frame.

The following assembling sequence may be used for integrating the power supply module of this structure:

(1) The passive elements are soldered onto the lead frame by using the surface mount technology.

(2) After being cleaned, each of the two MOSFET chips is soldered onto the lead frame; for the flip MOSFET chip, the flip MOSFET chip may be mounted and soldered onto the lead frame by using the flip chip mount technology; for the normal chip, the normal chip may be soldered onto the lead frame by using the normal chip mount technology through a soldering tin or the adhesive of high thermal conductivity.

(3) The copper pieces are soldered (for example, by using the soldering tin solder technology) or adhere (for example, through the adhesive of high thermal conductivity) to the MOSFET chips and the lead frame by using the copper piece mount technology to achieve interconnection of the MOSFETs and the lead frame, and then the whole module is cleaned.

(4) The flip chip mode IC chip is mounted and soldered onto the lead frame by using the flip-chip technology, and then the whole module is cleaned.

(5) Filling adhesive is filled in the bottom of the flip chip by using the underfill technology and cured in the bottom of the flip chip, and then the whole module is cleaned.

(6) The whole module is plastic encapsulated by using the plastic encapsulation technology.

(7) The power supply module is separated through stamping separation or cutting separation after the plastic encapsulating is completed.

It should be noted that, the cleaning in steps (2) to (5) or the underfill process in step (5) is optional, whether the cleaning processes and the underfill process are may be determined according to actual needs.

In addition, in an actual application, the above assembling sequence may be adjusted flexibly. For example, the chips are assembled first, and then the passive elements are assembled.

It should be noted that, the two MOSFETs in FIG. 6 may be two flip MOSFET chips with the vertical structure, but according to requirements of an application, normal MOSFET chips with the vertical structure may also be used. Definitely, the flip MOSFET chip or the normal MOSFET chip with the planar structure may also be used, but when the structure and packaging of the MOSFET are different, the number and the connection manner of the copper pieces mounted to the MOSFET chip require appropriate adjustment, the copper piece mounted to the MOSFET chip may be connected to different electrodes of the MOSFET. In addition, the structures and the packaging modes of the two MOSFET chips of the embodiment of the present invention may be completely the same or different.

The connection modes between the MOSFETs with different structures and packaging manners and the lead frame of the embodiment of the present invention are described briefly in the following.

A current between a source and a drain of the MOSFET with the vertical structure longitudinally passes between an upper surface and a lower surface of the chip, the source and the drain are located on the upper surface and the lower surface of the chip; a current between a source and a drain of the MOSFET with the planar structure horizontally passes along a single surface of the chip. The source and the drain are located on the same plane.

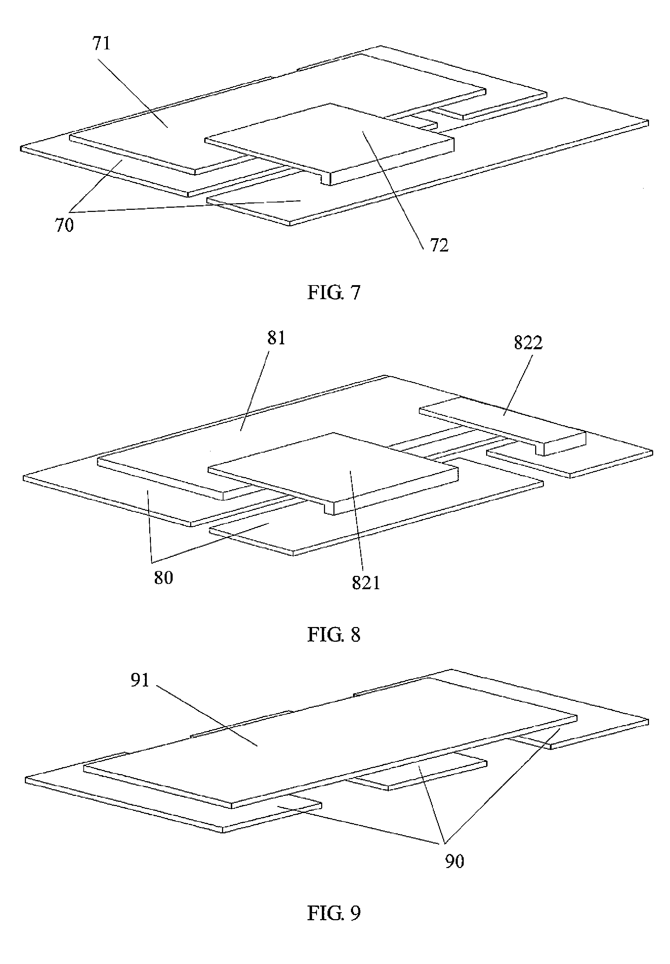

As shown in FIG. 7, FIG. 7 is a schematic connection diagram of a flip MOSFET chip with the vertical structure and a lead frame according to an embodiment of the present invention.

In the drawing, two electrodes on a lower surface of a flip MOSFET chip 71 are connected to a soldering end of a lead frame 70 through flip chip solder balls, an electrode on an upper surface is connected to the soldering end of the lead frame 70 through a copper piece 72 mounted to the electrode at the upper surface.

As shown in FIG. 8, FIG. 8 is a schematic connection diagram of a normal MOSFET chip with the vertical structure and a lead frame according to an embodiment of the present invention.

In the drawing, an electrode on a lower surface of a normal MOSFET chip 81 is connected to a soldering end of a lead frame 80 through a soldering tin or the adhesive of high thermal conductivity, two electrodes on an upper surface are connected to the soldering end of the lead frame 80 through copper pieces 821, 822 mounted to the two electrodes on the upper surface.

As shown in FIG. 9, FIG. 9 is a schematic connection diagram of a flip MOSFET chip with the vertical structure and a lead frame according to an embodiment of the present invention.

In the drawing, an electrode on a lower surface of a flip MOSFET chip 91 is soldered onto a soldering end of the lead frame 90 through solder balls of the flip chip, so as to connect three electrodes of the MOSFET to the lead frame 90.

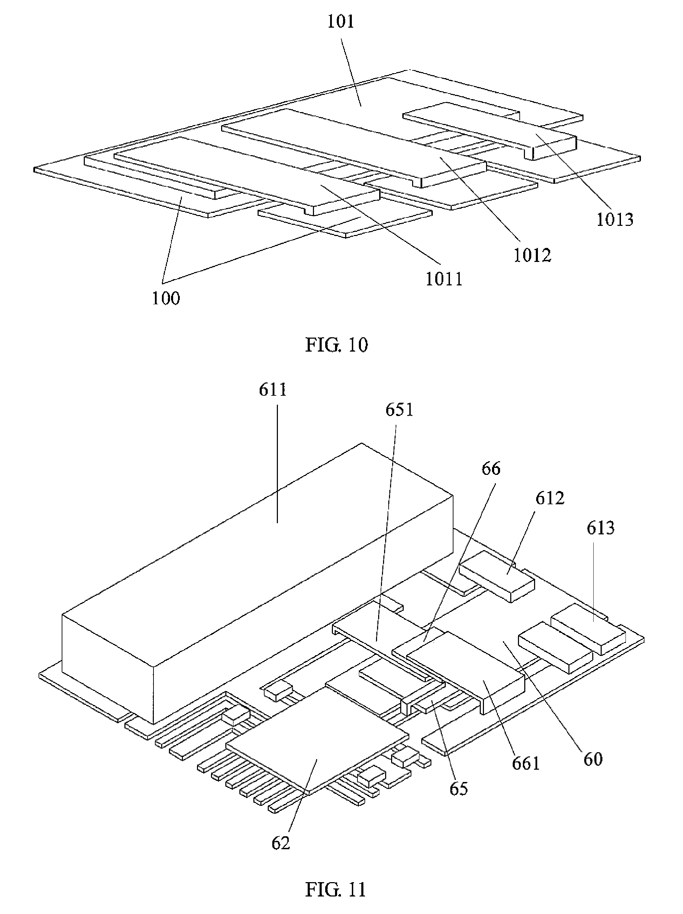

As shown in FIG. 10, FIG. 10 is a schematic connection diagram of a normal MOSFET chip with the planar structure and a lead frame according to an embodiment of the present invention.

In the drawing, a lower surface of a normal MOSFET chip 101 is connected to a soldering end of a lead frame 100 through a soldering tin or adhesive of high thermal conductivity, three electrodes on an upper surface are connected to the soldering end of the lead frame 100 through copper pieces 1011, 1012, 1013 mounted to the three electrodes on the upper surface.

In the above embodiment of the tri-chip structure, in an alternative solution of the copper piece, for 631, 641 in FIG. 6, 72 in FIG. 7, 821, 822 in FIG. 8, 1011, 1012, 1013 in FIG. 10, an aluminum strip may be used to replace the copper piece. The aluminum strip is soldered onto a corresponding chip surface and a lead frame surface by using the aluminum line and aluminum strip soldering technology. The aluminum strip is a strip-shaped interconnecting material with the shape similar to that of the copper piece.

It can be seen that, in the power supply module of the embodiment of the present invention, the interconnection of the MOSFET chips does not need gold wire or copper wire bonding, and the assembling of the IC chip does not need an embedded PCB or other substrates, but directly solders the IC to the lead frame by using the flip-chip technology, a connection distance between the chip and the lead frame is short, so that the parasitic parameters may be effectively decreased, a heat dissipation channel and heat dissipation performance of the chip are improved, the performance of the power supply module is improved, and the passive elements are also directly soldered onto the lead frame by using the surface mount technology. For the power supply module of the embodiment of the present invention, the costs are low, the number of internal solder joints is greatly reduced, failure probability of the solder joints is reduced, and reliability is increased.

As shown in FIG. 11, FIG. 11 is a schematic diagram of another tri-chip structure of a power supply module according to an embodiment of the present invention.

In this embodiment, passive elements 611, 612, 613 are soldered onto a lead frame 60 by using the surface mount technology. The passive elements may specifically be inductors, capacitors, and resistors. An IC and two MOSFETs are three independent chips, which are an IC chip 62 and MOSFET chips 65, 66 shown in the drawing. The IC chip 62 is a flip chip, and is mounted and soldered onto the lead frame 60 by using the flip-chip technology; the two MOSFET chips 65, 66 may be flip chips.

Different from the structure shown in FIG. 6, in this embodiment, the two MOSFET chips 65, 66 and two copper pieces 651, 661 are alternately stacked and mounted. As shown in FIG. 11, the MOSFET chip 65 is soldered onto the lead frame 60 through a manner corresponding to the chip packaging, the copper piece 651 is mounted to the MOSFET chip 65 by using the copper piece mount technology (that is, soldering or adhering), and then the MOSFET chip 66 is soldered onto the copper piece 651 through a manner corresponding to the chip packaging, the copper piece 661 is mounted to the MOSFET chip 66 by using the copper piece mount technology. The two copper pieces 651, 661 are configured to achieve the connection of the two MOSFET chips to the lead frame 60 and the interconnection of the two MOSFET chips.

The lead frame 60 in this embodiment may be of an array structure, that is, multiple modules are arranged in matrix in the lead frame.

The following assembling sequence may be used for integrating the power supply module with such a structure:

(1) The passive elements are soldered onto the lead frame by using the surface mount technology.

(2) The flip chip mode IC chip is mounted and soldered onto the lead frame by using the flip-chip technology, and then the whole module is cleaned.

(3) Filling adhesive is filled in the bottom of the flip chip by using the underfill technology and cured in the bottom of the flip chip, and then the whole module is cleaned.

(4) The two MOSFET chips and the two copper pieces are alternately stacked and mounted to complete the interconnection of the MOSFET chips and the lead frame, and then the whole module is cleaned.

(5) The whole module is plastic encapsulated by using the plastic encapsulation technology.

(6) The power supply module is separated through stamping separation or cutting separation after the plastic encapsulating is completed.

It should be noted that, the cleaning processes in steps (2) to (5) or the underfill process in step (3) are optional, whether to the cleaning processes and the underfill process are may be determined according to actual needs.

In addition, in an actual application, the above assembling sequence may be adjusted flexibly. For example, the chips are assembled first, and then the passive elements are assembled.

In addition, it should be noted that, in an actual application, the position and the stacking sequence of the MOSFET chips and the copper pieces may be flexibly adjusted according to the structure and the packaging mode of the MOSFET chips actually used if only the copper pieces mounted on the MOSFET chips can achieve the connection of the electrodes of the MOSFETs to the lead frame, which is not limited by the embodiment of the present invention.

It can be seen that, in the power supply module of the embodiment of the present invention, the interconnection of the MOSFET chips does not need gold wire or copper wire bonding, and the assembling of the IC chip does not need an embedded PCB or other substrates, but directly solders the IC onto the lead frame by using the flip-chip technology, a connection distance between the chip and the lead frame is short, so that the parasitic parameters may be effectively decreased, a heat dissipation channel and heat dissipation performance of the chip are improved, the performance of the power supply module is improved, and the passive elements are also directly soldered onto the lead frame by using the surface mount technology. For the power supply module of the embodiments of the present invention, the costs are low, the number of the internal solder joints is greatly reduced, failure probability of the solder joints is reduced, and reliability is increased.

In the embodiment of the tri-chip structure, in an alternative solution of the copper piece, the copper pieces in FIG. 11 may be replaced by an aluminum strip. The aluminum strip is soldered onto a corresponding chip surface and a lead frame surface by using the aluminum line and aluminum strip soldering technology. The aluminum strip is a strip-shaped interconnecting material with the shape similar to that of the copper piece.

It should be noted that, the IC the embodiments may only include the driver chip which is configured to drive the MOSFET driver circuit, or may be the control/driver chip with a PWM controller. The PWM controller is configured to control the above driver circuit.

The technical solutions according to the embodiments of the present invention may be used for semiconductor packaging and integrating of a POL (Point Of Load, point of load) power supply, the packaging and integrating of a PWM controller, and part of secondary power supply module integration.

It should be noted that all embodiments in the present specification adopt an incremental manner for description. The same or similar parts of the embodiments may be referred to each other. Each embodiment focuses on the differences thereof from other embodiments. Some or all of the modules may be selected to achieve the objective of the present invention according to actual needs. Persons with ordinary skill in the art can understand and implement the present invention without inventive work.

The above descriptions are merely exemplary embodiments of the present invention, but not intended to limit the protection scope of the present invention. Any modification, equivalent replacement, or improvement made without departing from the spirit and principle of the present invention should fall within the protection scope of the present invention.

## Claims

1. A power supply module, comprising: a lead frame, a passive element, an integrated circuit IC, and a power switch Metallic Oxide Semiconductor Field Effect Transistor MOSFET, wherein the passive element is soldered onto the lead frame by using the surface mount technology; and the IC is a flip chip and is mounted and soldered onto the lead frame.

2. The power supply module according to claim 1, wherein the passive element comprises an input capacitor, an output capacitor, and a power inductor.

3. The power supply module according to claim 2, wherein the IC is a driver chip of the MOSFET.

4. The power supply module according to any one of claims 1 to 3, wherein the MOSFET and the IC are integrated on one flip chip.

5. The power supply module according to claim 4, further comprising: a metal piece disposed on a back surface of the flip chip, and configured to dissipate heat and reduce electrical noise.

6. The power supply module according to claim 5, wherein
the metal piece is soldered onto the back surface of the flip chip; or
the metal piece adheres to the back surface of the flip chip through adhesive of high thermal conductivity.

7. The power supply module according to claim 5, wherein the metal piece has a bent edge, and the bent edge is electrically connected to the lead frame.

8. The power supply module according to any one of claims 1 to 3, wherein the MOSFET is two independent MOSFET chips, each of which is respectively soldered onto the lead frame.

9. The power supply module according to claim 8, wherein
any one of the two independent MOSFET chips is a flip MOSFET chip with a planar structure;
or, any one of the two independent MOSFET chips is a flip MOSFET chip with a vertical structure, the flip MOSFET chip with the vertical structure is mounted with a metal piece, and the metal piece is configured to achieve electrical connection of electrodes of the MOSFET chip to the lead frame;
or, any one of the two independent MOSFET chips is a normal MOSFET chip with a vertical structure, the normal MOSFET chip with the vertical structure is mounted with two metal pieces, and the metal pieces are configured to achieve electrical connection of electrodes of the MOSFET chip to the lead frame;
or, any one of the two independent MOSFET chips is a normal MOSFET chip with a planar structure, the normal MOSFET chip with the planar structure is mounted with three metal pieces, and the metal pieces are configured to achieve electrical connection of electrodes of the MOSFET chip to the lead frame.

10. The power supply module according to any one of claims 1 to 3, wherein the MOSFET is two independent flip MOSFET chips, the two flip MOSFET chips and two metal pieces are alternately stacked and mounted, and the two metal pieces are configured to achieve electrical connection of the MOSFET chips to the lead frame, and/ or electrical connection between the two MOSFET chips.

11. The power supply modules according to claim 5, 9, or 10, wherein the metal pieces are copper pieces or aluminum pieces.

12. A packaging and integrating method of a power supply module, comprising:
soldering a passive element onto a lead frame by using the surface mount technology;
mounting and soldering, by using a flip-chip technology, a flip chip on which a power switch Metallic Oxide Semiconductor Field Effect Transistor MOSFET and an integrated circuit IC are integrated to the lead frame to form a power supply module;
plastic encapsulating the power supply module; and
separating the power supply module after the plastic encapsulating is completed.

13. A packaging and integrating method of a power supply module, comprising:
soldering a passive element onto a lead frame by using the surface mount technology;
soldering each of two power switch Metallic Oxide Semiconductor Field Effect Transistor MOSFET chips to the lead frame;
mounting and soldering a flip-chip mode integrated circuit IC chip to the lead frame by using a flip-chip technology to form a power supply module;
plastic encapsulating the power supply module; and
separating the power supply module after the plastic encapsulating is completed.

14. The packaging and integrating method of a power supply module according to claim 12, wherein
any one of the MOSFET chips is a flip MOSFET chip with a planar structure;
or, any one of the MOSFET chips is a flip MOSFET chip with a vertical structure, and the method further comprises: mounting a metal piece to the MOSFET chip and making the metal piece be electrically connected to one electrode of the MOSFET and the lead frame;
or, any one of the MOSFET chips is a normal MOSFET chip with a vertical structure, and the method further comprises: mounting two metal pieces to the MOSFET chip and making each of the metal pieces be electrically connected to one electrode of the MOSFET and the lead frame, different metal pieces being connected to the different electrodes of the MOSFET; and
or, any one of the MOSFET chips is a normal MOSFET chip with a planar structure, and the method further comprises: mounting three metal pieces to the MOSFET chip and making each of the metal pieces be electrically connected to one electrode of the MOSFET and the lead frame, different metal pieces being connected to the different electrodes of the MOSFET.

15. A packaging and integrating method of a power supply module, comprising:
soldering a passive element onto a lead frame by using the surface mount technology;
mounting and soldering a flip-chip mode integrated circuit IC chip to the lead frame by using a flip-chip technology;
alternately stacking and mounting two power switch Metallic Oxide Semiconductor Field Effect Transistor MOSFET chips and two copper pieces to electrically connect the MOSFET chips with the lead frame to form a power supply module;
plastic encapsulating the power supply module; and
separating the power supply module after the plastic encapsulating is completed.
